(19) **Europäisches Patentamt / European Patent Office / Office européen des brevets**

(11) **EP 3 384 311 B1**

(12) **FASCICULE DE BREVET EUROPEEN**

(45) Date de publication et mention
de la délivrance du brevet:
**25.12.2019 Bulletin 2019/52**

(51) Int Cl.:
**G01S 7/40** *(2006.01)* **G01S 13/44** *(2006.01)*
**H01Q 3/26** *(2006.01)* **G01R 29/10** *(2006.01)*
**G01S 13/02** *(2006.01)*

(21) Numéro de dépôt: **16784805.0**

(22) Date de dépôt: **30.09.2016**

(86) Numéro de dépôt international:
**PCT/EP2016/073418**

(87) Numéro de publication internationale:
**WO 2017/060170 (13.04.2017 Gazette 2017/15)**

(54) **PROCÉDÉ DE CALIBRAGE D'UNE ANTENNE À BALAYAGE ÉLECTRONIQUE SECTORISÉE, ET DISPOSITIF DE MESURE CORRESPONDANTE**

KALIBRATIONSVERFAHREN EINER ELEKTRONISCH ABTASTENDEN SEKTORANTENNE UND ZUGEHÖRIGE MESSVORRICHTUNG

METHOD FOR CALIBRATING AN ELECTRONICALLY SCANNED SECTOR ANTENNA AND CORRESPONDING MEASURING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.10.2015 FR 1502084**

(43) Date de publication de la demande:
**10.10.2018 Bulletin 2018/41**

(73) Titulaire: **Thales**
**92400 Courbevoie (FR)**

(72) Inventeurs:
• **FREYSSINIER, Philippe**
**78851 Elancourt Cedex (FR)**
• **LECLERC, Frédéric**
**78851 Elancourt Cedex (FR)**
• **ADAMJEE, Alain**
**78851 Elancourt Cedex (FR)**
• **RENARD, Christian**
**78851 Elancourt Cedex (FR)**

• **LEVY, Pierre**
**78851 Elancourt Cedex (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**JP-A- 2001 201 525     US-A1- 2003 184 473**
**US-A1- 2011 248 796**

• **RAFAEL H MEDINA ET AL: "Calibration and validation of the CASA phased array antenna", RADAR CONFERENCE (EURAD), 2012 9TH EUROPEAN, IEEE, 31 octobre 2012 (2012-10-31), pages 614-617, XP032326785, ISBN: 978-1-4673-2471-7**

EP 3 384 311 B1

**Description**

La présente invention concerne un procédé de calibrage d'une antenne active sectorisée. Elle concerne également un dispositif de mesure pour la mise en œuvre d'un tel procédé.

L'invention s'applique notamment au domaine des antennes actives à balayage électronique, utilisées notamment pour équiper des radars ou des autodirecteurs de missiles, architecturées en secteurs pour effectuer une formation de faisceau par le calcul (FFC). Plus généralement, elle s'applique à toute antenne à balayage électronique sectorisée quelle qu'en soit l'application.

Une antenne à balayage électronique est une antenne à réseau d'éléments rayonnants qui comporte des dispositifs électroniques permettant des changements d'états de la forme du faisceau émis. Selon leur nature, ces dispositifs électroniques (déphaseurs, atténuateurs), qui sont connectés aux N éléments rayonnants pour former N voies actives, agissent sur la forme, la direction, la fréquence ou la polarisation de l'onde formée.

Une antenne à balayage électronique active correspond à une antenne dont les dispositifs d'amplification des signaux émis ou reçus sont inclus dans l'antenne et distribués au plus proche des éléments rayonnants, formant un réseau de voies actives d'émission et de réception. Classiquement, en réception les signaux issus des N éléments rayonnants sont regroupés après amplification, pondération et déphasage par des dispositifs physiques appelés distributeurs ou sommateurs de façon à former quatre secteurs de forme générale identique et appelées communément « quarts d'antenne ». Ces 4 quarts sont ensuite combinés entre eux par un dispositif physique incorporé dans l'antenne et appelé « Formateur de voies » qui forme les voies d'écartométrie classiques utilisés dans les radars ou les autodirecteurs notamment, ces voies étant la voie somme $\Sigma$, la voie différence en gisement $\Delta G$ et la voie différence en site $\Delta S$.

Une antenne à balayage électronique active sectorisée est une antenne qui ne regroupe pas directement les N éléments rayonnants pour former les quatre secteurs puis les voies d'écartométrie classiques mais en effectue M regroupements partiels contenant chacun un certain nombre de voies. Ces regroupements partiels portent le nom de voies secteurs et sont disponibles en sortie d'antenne. Une antenne sectorisée peut continuer de donner accès aux voies d'écartométrie classiques en supplément des sorties des voies secteurs. Les signaux d'écartométrie sont traités classiquement tandis que les signaux issus des secteurs sont utilisés par le système quel qu'il soit (radar, autodirecteur, ...) pour former, par le calcul un certain nombre de voies : les voies classiques d'écartométrie par exemple mais aussi tout autre type de combinaison des signaux issus des M secteurs destinés à améliorer le traitement de l'information. Ainsi, en plus de l'élaboration des voies d'écartométrie classiques, une antenne sectorisée élabore des signaux de sortie de voies secteurs correspondant aux regroupements partiels et disjoints d'un certain nombre de voies actives de l'antenne. Le fait d'avoir accès à ces différents signaux de secteurs permet de recomposer par le calcul un signal FFC selon toutes combinaisons du type :

$$Signal\_FFC = \sum_{i=1}^{M} B_i\, e^{j\psi_i}.Voie\_secteur(i) \qquad (1)$$

Où M est le nombre de secteurs, *Voie_secteur(i)* le signal issu du secteur d'ordre i, et $B_i e^{j\psi i}$ un poids complexe affecté au secteur i. En pratique M est un multiple de 4, M est par exemple égal à 16 ou 32.

Par la suite, l'équation (1) sera appelée équation FFC.

Pour la suite également, on appellera :

- Voie active : l'une des N voies unitaires composant l'antenne ;
- Voie classique d'écartométrie : l'une des trois voies d'écartométrie élaborées classiquement dans une antenne à balayage électronique traditionnelle ;
- Voie secteur : l'une des M voies secteurs élaborées par une antenne sectorisée ;
- Voie Antenne : terme générique désignant une voie secteur ou une voie classique.

Le réglage des antennes actives passe par une phase dite de calibrage qui consiste à mesurer sur l'antenne assemblée les dispersions d'amplitude et de phase en émission ou réception sur les N différentes voies actives de l'antenne, ces dispersions étant notamment dues aux dispersions des composants inclus dans les voies actives ainsi qu'aux dispersions d'assemblage. Ces dispersions sont ensuite compensées par des corrections adéquates appliquées aux commandes d'amplitude et de phase de chaque voie active grâce au calculateur de pointage. Dans le cas d'une antenne classique, ce calibrage se fait traditionnellement en sortie d'antenne sur la voie somme $\Sigma$.

Dans le cadre d'une antenne active sectorisée, les voies d'écartométrie classiques et les voies secteurs doivent être optimisées simultanément, problème qui ne se pose pas réellement pour une antenne classique.

Une fois calibrées avec la précision requise, les antennes actives qu'elles soient sectorisées ou non, sont à tester suivant un certain nombre de paramètres (diagrammes, PIRE, G/T, ...). Dans le cas d'une antenne sectorisée, le nombre de mesures à faire est bien plus important que pour une antenne classique et augmente à peu près proportionnellement au nombre de voies secteurs.

Ainsi pour une antenne sectorisée, se pose de façon aiguë les problèmes :

- de calibrage de l'antenne car plusieurs voies Antenne sont à optimiser simultanément (les voies classiques et les différentes voies secteurs) contrairement à une antenne classique où le calibrage s'effectue généralement sur la voie somme $\Sigma$ ;
- de test car beaucoup de données doivent être mesurées :

  - avec une précision au moins égale, voire accrue, par rapport à une antenne classique ;
  - dans un temps de mesure qui soit de la même classe que pour une antenne classique pour que les plannings des phases de test n'augmentent pas en durée.

Plusieurs documents traitent du calibrage des antennes à balayage classique, c'est le cas notamment des documents FR0904045, FR1103143 et FR1302928 ainsi que des documents de C. Renard: « Calibration et mesure faible coût d'une antenne à balayage électronique active » Workshop CNES, décembre 1998, de E.GRORUD et al. « Design and Measurement of an active array antenna for an airborne X-band SAR/MTI Radar », EUCAP Nice 2006 et de C. Renard : "Etalonnage des antennes aéroportées », CCT CNES janvier 2009.

Dans le cas des antennes sectorisées, il existe peu ou pas de solutions connues satisfaisantes.

En ce qui concerne les mesures de test, le nombre de voies à mesurer simultanément en réception dans une antenne à balayage électronique classique est limité aux trois voies classiques d'écartométrie et le problème de la simultanéité des mesures est résolu classiquement :

- soit en utilisant un analyseur de réseaux multiports capable de mesurer ces trois voies classiques en même temps, le nombre de ports de mesures de l'analyseur ne pouvant être augmenté indéfiniment et étant limité de façon standard à 8 actuellement ;
- soit en multiplexant les trois mesures sur un analyseur de réseau classique comportant un port de réception, le multiplexeur étant relié aux trois sorties de l'antenne à mesurer et comportant des commutateurs permettant d'orienter la voie souhaitée.

L'application de ces méthodes à une antenne qui comporterait par exemple 16 ou 32 secteurs à tester en réception n'est pas possible, soit parce que le nombre de voies Antenne à tester excède la capacité simultanée des analyseurs de réseau actuels, soit à cause de l'effet de traînée dans le cas des mesures multiplexées. En effet l'antenne étant en mouvement pendant la mesure, toutes les voies Antennes ne sont pas mesurées réellement au même endroit du diagramme d'antenne, ce qui n'est pas grave quand le nombre de voies est faible mais devient rédhibitoire quand le nombre de voies augmente fortement provoquant alors l'effet dit « de traînée ».

La mise à l'arrêt de l'antenne, nécessaire le temps d'effectuer la mesure, conduit à des temps de mesure rédhibitoires et ne peut pas non plus être une solution acceptable.

Un but de l'invention est notamment de permettre que les signaux FFC soient de même qualité que les signaux d'écartométrie classiques élaborés par l'antenne, et cela dans un temps de calibrage et de mesure d'une antenne sectorisée comparable à celui d'une antenne active à balayage électronique classique.

A cet effet, l'invention a pour objet un procédé de calibrage d'une antenne à balayage électronique composée d'éléments rayonnant formant chacun une voie active dans laquelle les signaux issus desdites voies sont regroupés d'une part pour former des signaux d'écartométrie, chaque signal d'écartométrie formant une voie d'écartométrie, et sont regroupés d'autre part selon des secteurs ($S_1$, $S_2$, ... $S_M$) pour former un signal par secteur formant une voie secteur, un faisceau par calcul étant formé à partir des signaux issus de chacun desdits secteurs, ledit procédé comportant au moins les étapes suivantes :

- mesurer la réponse à un signal de calibrage de chaque voie active à la fois sur la voie d'écartométrie somme et sur la voie de secteur auquel elle appartient, les réponses sur la voie somme permettant d'obtenir le calibrage de la voie somme ;
- calculer, pour chaque voie active, l'écart entre la moyenne des réponses mesurées sur la voie somme et la moyenne des réponses mesurées sur le secteur auquel elle appartient ;
- en phase opérationnelle, former ledit faisceau par le calcul à partir des mesures des signaux issus des voies secteurs calibrées avec le calibrage obtenue pour la voie somme, et corriger le calcul dudit faisceau en fonction dudit écart.

La mesure de la réponse à un signal de calibrage de chaque voie active à la fois sur la voie d'écartométrie somme et sur la voie de secteur auquel elle appartient est par exemple effectuée dans une même séquence instantanée de mesure.

Les mesures des signaux issues des voies secteurs sont par exemple effectuées dans une même séquence instantanée de mesure.

Dans un mode de mise en œuvre particulier, le signal reçu par le faisceau formé par le calcul, noté *Signal_FFC,* est obtenu selon la relation suivante :

$$Signal\_FFC = \sum_{i=1}^{M} B_i\, e^{j\psi_i}.Voie\_secteur(i).Cor\_secteur(i)$$

où :

- M est le nombre de secteurs ;
- *Voie_secteur*(*i*) est la mesure du signal issu de la voie du i$^{ème}$ secteur calibrée avec le calibrage obtenue pour la voie somme, i variant de 1 à M ;
- $B_i e^{j\psi_i}$ est un poids complexe affecté au i$^{ème}$ secteur ;
- *Cor_secteur*(*i*) représente l'écart entre la moyenne des réponses mesurées sur la voie somme et la moyenne des réponses mesurées sur le i$^{ème}$ secteur.

L'invention concerne également un dispositif de mesure pour la mise en œuvre dudit procédé, lequel comporte au moins :

- un analyseur de réseau multiports comportant un nombre total P de récepteurs, ledit analyseur étant apte à mesurer les signaux issus desdites voies actives en réponse audit signal de calibrage ;
- un ensemble de K commutateurs ayant chacun Q voies d'entrées et une voie de sortie sur laquelle est branchée l'une desdites voies d'entrées, lesdits commutateurs étant pilotés par ledit analyseur, lesdites voies d'entrées étant aptes à recevoir chacune un signal issus d'une voie active de ladite antenne en réponse audit signal de calibrage, lesdites voies de sorties étant reliées chacune à un des P récepteurs ;

ledit analyseur déclenchant successivement Q mesure selon la séquence suivante :

- à la réception d'un signal d'ordre de mesure, ledit analyseur pilotant lesdits commutateurs afin qu'ils commutent chacun leur première voie d'entrée sur leur voie de sortie puis déclenchant la mesure sur ses P récepteurs des signaux issus de P premières voies actives ;
- puis ledit analyseur pilotant lesdits commutateurs afin qu'ils sélectionnent chacun leur deuxième voie d'entrée sur leur voie de sortie, puis déclenchant la mesure sur ses P récepteurs des signaux issus de P voies actives suivantes ;

et ainsi de suite jusqu'à ce que ledit analyseur pilotant lesdits commutateurs leur fasse brancher chacun leur Q$^{ème}$ voie d'entrée sur leur voie de sortie.

Un amplificateur est par exemple disposé entre chaque sortie de commutateur et l'entrée du récepteur auquel elle est reliée. Un port dudit analyseur comporte par exemple au moins un module d'émission pour générer le signal d'émission destiné à être émis vers lesdites voies.

Ledit dispositif comporte par exemple un coupleur en sortie dudit module d'émission, ledit port comportant au moins un récepteur pour recevoir un signal de référence issu dudit signal d'émission via ledit coupleur. Ledit port comporte par exemple un deuxième récepteur recevant un signal issu d'un réseau formé de quelques éléments rayonnants de ladite antenne.

D'autres caractéristiques et avantages de l'invention apparaîtront à l'aide de la description qui suit, faite en regard de dessins annexés qui représentent :

- la figure 1, une illustration du principe de réalisation d'un formateur de voie utilisé dans une antenne à balayage électronique sectorisée ;
- la figure 2, différentes étapes possibles du procédé selon l'invention ;
- la figure 3, un exemple de réalisation pour la mise en œuvre du procédé selon l'invention.

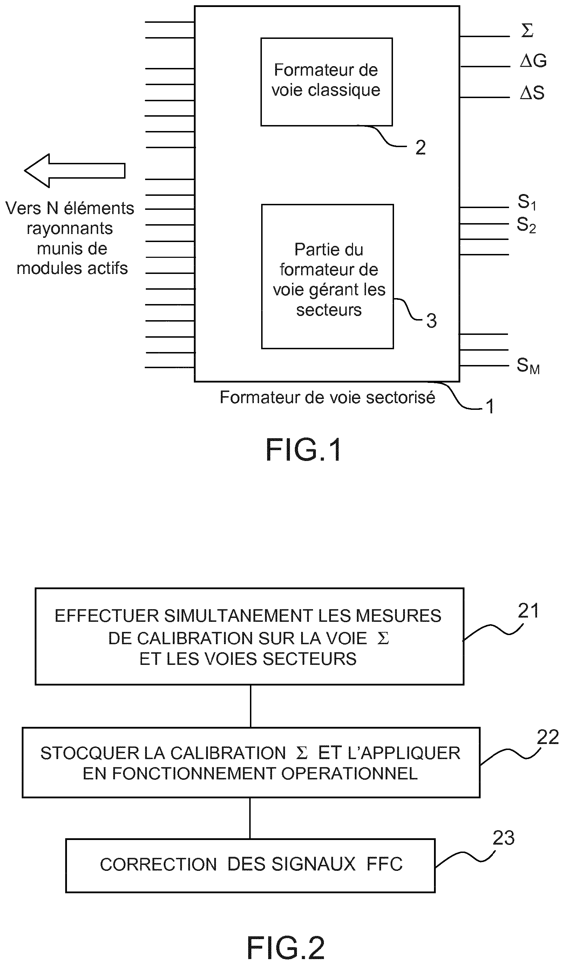

La figure 1 illustre le principe de réalisation d'un formateur de voie 1 utilisé pour une antenne à balayage électronique active sectorisée.

Dans une antenne active classique, les voies classiques d'écartométrie $\Sigma$, $\Delta S$, $\Delta G$, sont formées physiquement par l'antenne au travers d'un formateur de voies. La mesure de calibrage de chaque voie active est faite entre l'entrée de l'élément rayonnant et la sortie de la voie somme $\Sigma$ du formateur de voies dans l'opération de calibrage. La qualité du calibrage sur la voie $\Sigma$ associée aux précisions de fonctionnement que l'on rencontre classiquement sur les formateurs de voies suffit à garantir le fonctionnement correct de l'ensemble des trois voies d'écartométrie.

Dans le cas d'une antenne sectorisée, la formation simultanée des voies d'écartométrie classiques et des voies secteurs est assurée par un formateur de voies spécifiques présenté schématiquement par la figure 1. Il comporte par exemple une formateur 2 de voies classiques destiné à l'élaboration des voies d'écartométrie classiques $\Sigma$, $\Delta S$, $\Delta G$ et une partie 3 gérant les secteurs $S_1$, $S_2$, ... $S_M$.

Chaque voie active de l'antenne issue d'un élément rayonnant ressort simultanément sur les voies d'écartométrie classiques et sur la sortie du secteur auquel elle appartient mais le trajet qu'elle suit n'est pas le même. Plus précisément, la différence de trajet entre la voie somme $\Sigma$ et la voie secteur est la même pour toutes les voies actives appartenant à un même secteur. Les trajets sont communs jusqu'au formateur de voies 1 et diffèrent ensuite au sein même de ce dispositif 1.

Si on choisit de continuer de faire le calibrage de l'antenne sur la voie somme $\Sigma$ comme sur une antenne classique, les corrections apportées lors du pointage de l'antenne conduisent à des voies d'écartométrie bien réglées mais les signaux issus des différents secteurs ne sont pas cohérents entre eux car l'écart de trajet entre la voie somme $\Sigma$ et la sortie secteur correspondante n'est pas le même de secteur à secteur. Si on choisit de faire l'inverse, c'est-à-dire de calibrer sur les voies secteurs, les voies d'écartométrie formées physiquement par l'antenne ne sont pas bonnes (remontée des lobes secondaires et déviation d'axe notamment) et ne peuvent donc pas être utilisées.

Ceci constitue donc un premier problème rencontré. Il faut en effet optimiser simultanément les différentes voies d'antenne.

Par ailleurs, l'application de la formule du calcul FFC met en lumière un besoin de précision accrue dans la mesure de l'antenne sectorisée par rapport à une antenne classique. En effet, la sommation d'erreurs par secteur d'antenne produit des effets importants sur la remontée des premiers lobes secondaires et sur la déviation d'axe. Ce problème n'a pas d'équivalent dans les antennes classiques qui concentrent les efforts à faire sur les dispositifs physiques de regroupement des voies et non pas sur la mesure. Enfin, la quantité de mesures à effectuer dans une antenne sectorisée est à peu près proportionnelle au nombre de secteurs de l'antenne tandis que les plannings de développement et de test de ce type d'antenne impose tout naturellement des délais de test qui sont sensiblement de la même classe que pour les antennes classiques.

Comme indiqué précédemment, un problème posé est donc de développer une méthode de calibrage permettant d'optimiser simultanément les voies d'écartométrie classiques et les voies secteurs, avec un moyen de test correspondant ayant pour caractéristiques principales une très bonne précision de mesure et une capacité à faire une multiplicité de mesures dans un temps comparable à celui nécessaire pour une antenne classique, 5 à 10 fois plus de mesures par exemple.

La figure 2 illustre les étapes possibles du procédé selon l'invention. Ces étapes réalisent en fait les opérations suivantes :

- Faire le calibrage sur la voie somme $\Sigma$ de façon classique pour optimiser les voies d'écartométrie grâce au formateur de voie inséré dans l'antenne ;
- Mesurer le défaut de réglage entre la voie somme $\Sigma$ et les voies secteurs ;
- Corriger la composition des secteurs entre eux par un facteur compensant ce défaut de réglage différentiel.

Ainsi, dans une première étape 21, on effectue simultanément les mesures de calibrage sur la voie somme $\Sigma$ et les voies secteurs. Plus précisément, pour optimiser simultanément l'antenne sur les voies d'écartométrie classiques et les voies secteurs servant à la formation de faisceau par le calcul FFC, on mesure simultanément, ou presque, la réponse à un signal de test de chaque voie active à la fois sur la voie somme $\Sigma$ et sur la voie secteur auquel elle appartient.

Dans une étape suivante 22, le calibrage sur la voie somme $\Sigma$ est stockée. Plus particulièrement ce calibrage prend la forme d'une table, constituée des mesures des réponses de chaque voie active au signal de test, est par exemple stockée dans le pointeur de l'antenne comme pour les antennes classiques. Ce calibrage est appliqué à l'antenne. Dans ces conditions le fonctionnement opérationnel de l'antenne est optimisé sur ses voies d'écartométrie mais ne l'est pas sur ses voies secteurs. Dans cette étape également, la différence entre la table de calibrage de la voie somme $\Sigma$ et la table de calibrage sur les voies secteurs est stockée. La table de calibrage d'un secteur est constituée, pour chaque secteur, des réponses de chaque voie active appartenant à ce secteur. La table de calibrage sur les voies secteurs regroupe l'ensemble des tables de calibrage des secteurs. En l'état, ces calibrages sur les voies secteurs ne permettent pas un fonctionnement optimisé sur ces voies secteurs.

Selon l'invention, l'équation FFC définie par la revendication 1 est modifiée en fonction de cette différence entre les tables.

Dans une étape suivante 23, on détermine donc une correction à effectuer sur les signaux FFC en phase opérationnelle, c'est-à-dire lorsque l'antenne est en fonctionnement. Plus précisément, on détermine la correction à appliquer sure les signaux obtenus selon l'équation FFC définie par la relation (1). Avec cette correction, un signal FFC est obtenu selon la relation (2) suivante :

$$Signal\_FFC = \sum_{i=1}^{M} B_i\, e^{j\psi_i}.Voie\_secteur(i).Cor\_secteur(i)$$

Comme pour la relation (1), $B_i e^{j\psi i}$ est un poids complexe affecté au secteur i.

*Voie_secteur(i)* est la mesure du signal en sortie du secteur i en réponse au signal de test à partir duquel est effectué le calibrage de la voie somme $\Sigma$. C'est donc une mesure non optimisée pour le calibrage du signal FFC.

Le signal *Cor_secteur(i)*, de chaque secteur i, permet d'optimiser le signal FFC, c'est-à-dire le calibrage. Il correspond à l'écart entre le calibrage d'une voie active sur la voie somme $\Sigma$, *Cal_voie$\Sigma$(i),* et le calibrage de cette voie active sur le secteur *i* auquel elle appartient, *Cal_secteur(i)*. Plus précisément, les quantités *Cal_voie$\Sigma$(i)* et *Cal_secteur(i)* sont moyennées sur l'ensemble des voie actives appartenant à un même secteur *i* :

$$Cor\_secteur(i) = \overline{Cal\_voie\Sigma(i)} - \overline{Cal\_secteur(i)} \qquad (3)$$

Dans l'équation FFC corrigée de la relation (2), il est nécessaire de pouvoir mesurer les éléments *Cor_secteur(i)*, et *Voie_secteur(i)* avec une très bonne précision pour que la contribution des erreurs de mesure à la sommation pondérée des secteurs soit négligeable.

Un dispositif selon l'invention permet avantageusement que ces précisions souhaitées dans l'équation FFC soient atteintes, tant pour le terme de correction que pour la mesure elle-même des voies secteur.

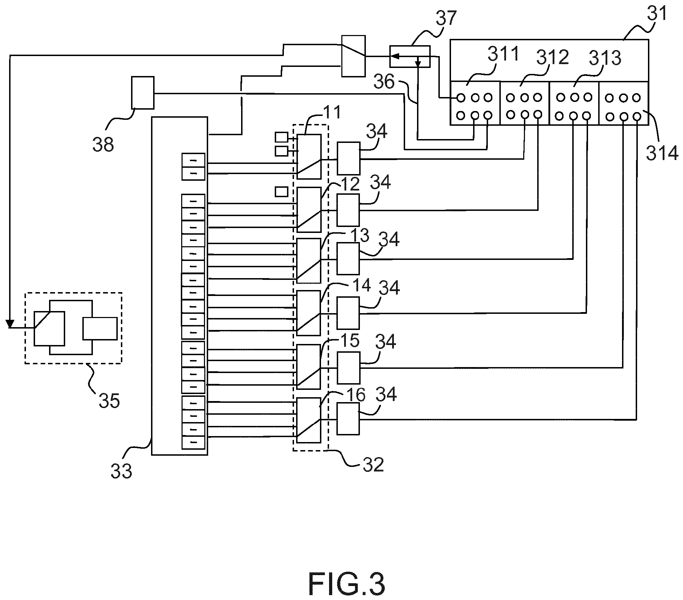

La figure 3 présente un exemple de réalisation possible d'un dispositif selon l'invention. Il a notamment pour but de permettre des mesures simultanées ou presque des paramètres clés de l'équation FFC. A cet effet :

-   la réponse de chaque voie active est mesurée sur la voie somme $\Sigma$ et sur sa sortie secteur dans une même séquence instantanée de mesure, ce qui minimise l'erreur commise sur la différence de réponse et donc sur le terme *Cor_secteur(i)* ;
-   les réponses des M secteurs sur chaque point de la cartographie en champs proche, repéré selon des coordonnées cartésiennes X, Y, ou du diagramme en champ lointain, repéré en coordonnées polaires $(\theta, \varphi)$, sont mesurées dans la même séquence instantanée de mesure. Dans ces conditions, l'équation FFC somme des contributions qui sont affectées d'une erreur différentielle minimale car mesurées au même instant.

Le dispositif selon l'invention comporte un analyseur de réseau multiports 31 et ensemble de commutateurs 32, formant par exemple un boîtier de commutation, piloté par l'analyseur de réseau. Dans l'exemple de réalisation de la figure 3, le dispositif est compatible de la mesure de 24 signaux dont 21 issus d'une antenne à tester.

Le boîtier de commutation comporte six commutateurs 11, 12, 13, 14, 15, 16 commutant chacun quatre voies sur une voie. Ces commutateurs sélectionnent les voies d'antenne 33 vers l'analyseur 31. Dans l'exemple de la figure 3, quatre commutateurs 13, 14, 15, 16 ont leurs quatre entrées reliées chacune à une voie d'antenne. Un deuxième commutateur 12 a trois entrées reliées chacune à une voie d'antenne et une entrée, inhibée, reliée par exemple à une charge. Un premier commutateur 11 a deux entrées reliées chacune à une voie d'antenne et deux entrées inhibées, reliées chacune par exemple à une charge. Ainsi, l'ensemble des commutateurs relie 21 voies d'antennes à l'analyseur 31. Un amplificateur 34 est par exemple disposé en sortie de chaque commutateur, en amont de l'analyseur, pour amplifier les signaux d'antennes mesurés. Cet amplificateur 34 est facultatif et peut être supprimé si la dynamique de mesure est suffisante. Dans l'exemple de la figure 3, l'analyseur comporte quatre ports 311, 312, 313, 314. Chaque port est formé d'un module d'émission et de deux ports qui peuvent être rendus indépendants, ce qui permet de disposer de 8 récepteurs. Dans l'exemple de la figure 3, un premier port 311 est utilisé :

-   pour générer le signal d'émission destiné à la sonde disposée en champ proche, cette sonde émettant le signal de test ou de référence vers les voies d'antennes 33, elle peut être remplacée par une un cornet source d'une base compacte ;
-   avec un premier récepteur recevant le signal de référence issu du signal émission via une voie couplée 36, à cet effet un coupleur 37 étant connecté en sortie d'émission ;

- avec un deuxième récepteur recevant un signal issu d'un mini-réseau d'éléments rayonnants 38 permettant la surveillance d'une dérive de mesure, ce mini-réseau étant composé de quelques éléments rayonnants de l'antenne.

Les trois autres ports 312, 313, 314 sont utilisés uniquement en réception pour tester les voies antennes.

Le dispositif selon l'invention fonctionne comme décrit ci-après.

Le dispositif est par exemple couplé à un système de motorisation de la sonde 35 permettant le déplacement de cette dernière vers les différentes voies à calibrer. Le système de motorisation envoie par exemple un signal d'ordre de mesure, ou top de mesure, à l'analyseur de réseau 31 dans les circonstances suivantes :

- en phase de calibrage, quand le système de motorisation arrête la sonde devant un élément rayonnant d'une voie active à calibrer ;
- en mesure de diagramme en champ proche quand le système de motorisation passe, sans s'arrêter, à une position (X, Y) donnée de la cartographie en champ proche de l'antenne sous test ;
- en mesure de diagramme en champ lointain quand le système de motorisation passe, sans s'arrêter, dans une direction $(\theta, \varphi)$ donnée du diagramme de rayonnement.

A la réception de ce top, l'analyseur de réseau 31 déclenche successivement quatre mesures, une mesure consistant en la mesure simultanée de six voies d'antennes sur les six récepteurs des ports 312, 313, 314 de l'analyseur. Les mesures se font de la manière suivante :

- une fois le signal reçu, l'analyseur de réseau 31 pilote la boîte de commutation 32 pour mettre les 6 commutateurs chacun sur leur voie 1 puis déclenche la mesure sur ses 6 récepteurs pour les six premières voies issues de l'antenne ;
- une fois cette première mesure effectuée, l'analyseur de réseau pilote la boîte de commutation pour mettre les 6 commutateurs chacun sur leur voie 2, puis déclenche la mesure sur les 6 autres voies issues de l'antenne ;
- les 12 autres voies d'antenne à mesurer le sont de la même manière avec la commande des commutateurs sur leurs voies 3 et 4.

En termes de temps de mesure et d'effet de traînée, le système multivoies du dispositif selon l'invention est équivalent à un système qui multiplexerait la mesure de 4 voies sur un récepteur unique et est donc comparable aux systèmes préexistants pour mesurer les antennes classiques, ce qui résout un des problèmes posés.

Le dispositif, qui est décrit pour mesurer 24 signaux, peut évoluer en jouant notamment :

- sur le nombre de ports de mesures simultanées de l'analyseur réseau 31 ;
- sur le nombre de positions possibles de la boîte de commutation 32 pour augmenter le nombre de mesures consécutives effectuées à partir d'un même top de mesure.

La répartition entre le nombre de voies de l'analyseur de réseau 31 et le nombre de commutateurs dans la boîte 32 peut être adaptée en fonction du nombre de voies à mesurer simultanément. Préférentiellement et pour réduire les effets de traînée, l'analyseur de réseau comporte le plus grand nombre de ports possible.

La précision de mesure est atteinte par le fait que l'analyseur de réseau permet de garantir la précision nécessaire jusqu'à des niveaux de -60 à -70 dBm mais surtout par le fait que les informations qu'il est nécessaire de mesurer pour utiliser l'équation FFC, sont mesurées simultanément ou presque et qu'il n'y a pas de dérive d'un système de mesure pendant des temps si courts. A titre d'exemple, en champ proche entre deux points mesures, il s'écoule un temps de l'ordre de 0,5 secondes et une seule partie de ce temps est utilisée pour faire les 24 mesures, la majeure partie de ce temps étant consacrée au déplacement physique d'un point à l'autre.

En pratique, pour surveiller les effets de dérive à moyen terme des systèmes de mesure, on peut, par exemple, utiliser les deux mesures dédiées suivantes :

- La mesure du mini-réseau 38 comme indiqué précédemment mais qui ne passe pas par la boîte de commutation, ce type de surveillance étant classiquement utilisé pour les moyens de mesures en champ proche ;
- Une mesure dédiée, non représentée par la figure 3, peut être ajoutée pour surveiller la dérive de la boîte de commutation 32 et de la partie optionnelle d'amplification 34. Elle est par exemple mise en place en dérivant une partie du signal destiné à la sonde pour le connecter sur l'une des deux voies encore disponibles sur les entrées de commutation de la boîte 32. Ainsi, à chaque point de mesure de la cartographie champ proche ou du diagramme champ lointain, on obtient un relevé de ce paramètre permettant de suivre l'éventuelle dérive moyen terme de l'ensemble commutation/amplification 32, 34.

En application champ proche, le dispositif de mesure est par exemple fixe et posé sur une table à l'intérieur d'une chambre sourde. Dans une version compacte, le dispositif est, par exemple, embarqué sur la partie mobile d'un système motorisé pour éviter d'avoir à mettre en place un système de câbles entre l'antenne à calibrer et l'analyseur de réseau encaissant les mouvements de l'antenne pendant les mesures.

La partie du dispositif illustrée par la figure 3 destinée aux mesures est complétée par des moyens de traitement et de stockage pour effectuer notamment les calculs des relations (2) et (3) et pour stocker la table de calibrage de la voie somme $\sum$ et la table des corrections à apporter pour optimiser les voies secteurs. Ces moyens peuvent être partagés avec le radar ou le système couplé à l'antenne. En particulier, la table de calibrage de la voie $\sum$ peut être stockée dans le pointeur et la table des corrections peut être stockée dans le système qui effectue les calculs de FFC.

**Revendications**

1. Procédé de calibrage d'une antenne à balayage électronique composée d'éléments rayonnant formant chacun une voie active dans laquelle les signaux issus desdites voies sont regroupés d'une part pour former des signaux d'écartométrie, chaque signal d'écartométrie formant une voie d'écartométrie, et sont regroupés d'autre part selon des secteurs (S$_1$, S$_2$, ... S$_M$) pour former un signal par secteur formant une voie secteur, un faisceau par calcul étant formé à partir des signaux issus de chacun desdits secteurs, **caractérisé en ce qu'**il comporte au moins les étapes suivantes :

   - mesurer (21) la réponse à un signal de calibrage de chaque voie active à la fois sur la voie d'écartométrie somme et sur la voie de secteur auquel elle appartient, les réponses sur la voie somme permettant d'obtenir le calibrage de la voie somme ;
   - calculer, pour chaque voie active, l'écart entre la moyenne des réponses mesurées sur la voie somme et la moyenne des réponses mesurées sur le secteur auquel elle appartient ;
   - en phase opérationnelle, former ledit faisceau par le calcul à partir des mesures des signaux issus des voies secteurs calibrées avec le calibrage obtenue pour la voie somme, et corriger (23) le calcul dudit faisceau en fonction dudit écart.

2. Procédé selon la revendication 1, **caractérisé en ce que** la mesure de la réponse à un signal de calibrage de chaque voie active à la fois sur la voie d'écartométrie somme et sur la voie de secteur auquel elle appartient est effectuée dans une même séquence instantanée de mesure.

3. Procédé selon l'une quelconque des revendications précédentes, **caractérisé en ce que** les mesures des signaux issues des voies secteurs sont effectuées dans une même séquence instantanée de mesure.

4. Procédé selon l'une quelconque des revendications précédentes, **caractérisé en ce que** le signal reçu par le faisceau formé par le calcul, noté *Signal_FFC,* est obtenu selon la relation suivante :

$$Signal\_FFC = \sum_{i=1}^{M} B_i\, e^{j\psi_i}.Voie\_secteur(i).Cor\_secteur(i)$$

où :

   - M est le nombre de secteurs ;
   - *Voie_secteur(i)* est la mesure du signal issu de la voie du i$^{\text{ème}}$ secteur calibrée avec le calibrage obtenue pour la voie somme, i variant de 1 à M ;
   - $B_i e^{j\psi_i}$ est un poids complexe affecté au i$^{\text{ème}}$ secteur ;
   - *Cor_secteur(i)* représente l'écart entre la moyenne des réponses mesurées sur la voie somme et la moyenne des réponses mesurées sur le i$^{\text{ème}}$ secteur.

5. Dispositif de mesure pour la mise en œuvre du procédé selon l'une quelconque des revendications précédentes, **caractérisé en ce qu'**il comporte au moins :

   - un analyseur de réseau (31) multiports comportant un nombre total P de récepteurs, ledit analyseur étant apte à mesurer les signaux issus desdites voies actives en réponse audit signal de calibrage ;
- un ensemble (32) de K commutateurs (11, 12, 13, 14, 15, 16) ayant chacun Q voies d'entrées et une voie de sortie sur laquelle est branchée l'une desdites voies d'entrées, lesdits commutateurs étant pilotés par ledit analyseur, lesdites voies d'entrées étant aptes à recevoir chacune un signal issus d'une voie active de ladite antenne en réponse audit signal de calibrage, lesdites voies de sorties étant reliées chacune à un des P récepteurs ;
ledit analyseur (31) déclenchant successivement Q mesure selon la séquence suivante :

- à la réception d'un signal d'ordre de mesure, ledit analyseur (31) pilotant lesdits commutateurs afin qu'ils commutent chacun leur première voie d'entrée sur leur voie de sortie puis déclenchant la mesure sur ses P récepteurs des signaux issus de P premières voies actives ;
- puis ledit analyseur (31) pilotant lesdits commutateurs afin qu'ils sélectionnent chacun leur deuxième voie d'entrée sur leur voie de sortie, puis déclenchant la mesure sur ses P récepteurs des signaux issus de P voies actives suivantes ;

et ainsi de suite jusqu'à ce que ledit analyseur (31) pilotant lesdits commutateurs leur fasse brancher chacun leur Qème voie d'entrée sur leur voie de sortie.

6. Dispositif selon la revendication 5, **caractérisé en ce qu'**un amplificateur (34) est disposé entre chaque sortie de commutateur et l'entrée du récepteur auquel elle est reliée.

7. Dispositif selon l'une quelconque des revendications 5 ou 6, **caractérisé en ce qu'**un port (311) dudit analyseur (31) comporte au moins un module d'émission pour générer le signal d'émission destiné à être émis vers lesdites voies (33).

8. Dispositif selon la revendication 7, **caractérisé en ce qu'**il comporte un coupleur (37) en sortie dudit module d'émission, ledit port (311) comportant au moins un récepteur pour recevoir un signal de référence issu dudit signal d'émission via ledit coupleur (37).

9. Dispositif selon l'une quelconque des revendications 7 ou 8, **caractérisé en ce que** ledit port (311) comporte un deuxième récepteur recevant un signal issu d'un réseau (38) formé de quelques éléments rayonnants de ladite antenne.

## Patentansprüche

1. Kalibrierungsverfahren einer elektronisch abtastenden Antenne, bestehend aus Strahlelementen, welche jeweils einen aktiven Kanal bilden, in welchem die aus den Kanälen stammenden Signale einerseits zum Bilden von Abweichungsmessungssignalen zusammengefasst werden, wobei jedes Abweichungsmessungssignal einen Abweichungsmessungskanal bildet, und andererseits gemäß Sektoren ($S_1$, $S_2$, ... $S_M$) zusammengefasst werden, um ein Signal pro Sektor zu bilden, welches einen Sektorkanal bildet, wobei pro Berechnung ein Strahl anhand der aus jedem der Sektoren stammenden Signale gebildet wird, **dadurch gekennzeichnet, dass** es mindestens folgende Schritte beinhaltet:

- Messen (21) der Antwort auf ein Kalibriersignal jedes aktiven Kanals, gleichzeitig auf dem Abweichungsmessungs-Summenkanal und auf demjenigen Sektorkanal, zu welchem er gehört, wobei die Antworten auf dem Summenkanal es ermöglichen, die Kalibrierung des Summenkanals zu erzielen;
- Berechnen, für jeden aktiven Kanal, der Abweichung zwischen dem Mittelwert der auf dem Summenkanal gemessenen Antworten und dem Mittelwert der auf demjenigen Sektor gemessenen Antworten, zu welchem er gehört;
- in der Betriebsphase, Bilden des Strahls durch die Berechnung, anhand der Messungen der aus den Sektorkanälen stammenden Signale, welche mit der Kalibrierung kalibriert wurden, welche für den Summenkanal erzielt wurde, und Korrigieren (23) der Berechnung des Strahls angesichts der Abweichung.

2. Verfahren nach Anspruch 1, **dadurch gekennzeichnet, dass** die Messung der Antwort auf ein Kalibriersignal jedes aktiven Kanals gleichzeitig auf dem Abweichungsmessungs-Summenkanal und auf demjenigen Sektorkanal, zu welchem er gehört, in einer gleichen augenblicklichen Messsequenz erfolgt.

3.  Verfahren nach einem der vorhergehenden Ansprüche, **dadurch gekennzeichnet, dass** die Messungen der aus den Sektorkanälen stammenden Signale in einer gleichen augenblicklichen Messsequenz erfolgen.

4.  Verfahren nach einem der vorhergehenden Ansprüche, **dadurch gekennzeichnet, dass** das durch den durch die Berechnung gebildeten Strahl empfangene Signal, bezeichnet *Signal_FFC,* entsprechend folgender Beziehung erzielt wird:

$$Signal\_FFC = \sum_{i=1}^{M} B_i\, e^{j\psi_i}.Voie\_secteur(i).Cor\_secteur(i)$$

wobei:

- M die Anzahl der Sektoren ist;
- *Voie_secteur(i)* (Sektor_Kanal) die Messung des aus dem Kanal des i-ten mit der für den Summenkanal erzielten Kalibrierung kalibrierten Sektors ist, wobei i von 1 bis M variiert;
- $B_i e^{j\psi i}$ ein komplexes Gewicht ist, welches dem i-ten Sektor zugeordnet ist;
- *Cor_secteur(i)* (Sektor_Korrektur) die Abweichung zwischen dem Mittelwert der auf dem Summenkanal gemessenen Antworten und dem Mittelwert der auf dem i-ten Sektor gemessenen Antworten ist.

5.  Vorrichtung zum Umsetzen des Verfahrens nach einem der vorhergehenden Ansprüche, **dadurch gekennzeichnet, dass** es mindestens Folgendes beinhaltet:

- einen Multiport-Netzwerkanalysator (31), welcher eine Gesamtanzahl P von Empfängern beinhaltet, wobei der Analysator in der Lage ist, die aus den aktiven Kanälen in Reaktion auf das Kalibriersignal stammenden Signale zu messen;
- eine Gruppe (32) von K Umschaltern (11, 12, 13, 14, 15, 16), welche jeweils Q Eingangskanäle und einen Ausgangskanal besitzen, an welchen einer der Eingangskanäle angeschlossen ist, wobei die Umschalter durch den Analysator gesteuert werden, wobei die Eingangskanäle in der Lage sind, jeweils ein Signal zu empfangen, welches aus einem aktiven Kanal der Antenne in Reaktion auf das Kalibriersignal stammt, wobei die Ausgangskanäle jeweils mit einem der P Empfänger verbunden sind,

wobei der Analysator (31) nacheinander Q Messungen gemäß der folgenden Sequenz auslöst:

- beim Empfang eines Messbefehlssignals steuert der Analysator (31) die Umschalter, damit sie jeweils ihren ersten Eingangskanal auf den Ausgangskanal umschalten, und löst anschließend die Messung an seinen P Empfängern der aus den P ersten aktiven Kanäle stammenden Signale aus;
- anschließend steuert der Analysator (31) die Umschalter, damit sie jeweils ihren zweiten Eingangskanal an ihrem Ausgangskanal auswählen, und löst anschließend die Messung an seinen P Empfängern der aus den P folgenden aktiven Kanäle stammenden Signale aus;

und so weiter, bis der Analysator (31), welche die Umschalter steuert, diese dazu veranlasst, jeweils ihren Q-ten Eingangskanal an ihren Ausgangskanal anzuschließen.

6.  Vorrichtung nach Anspruch 5, **dadurch gekennzeichnet, dass** ein Verstärker (34) zwischen jedem Umschalterausgang und dem Eingang desjenigen Empfängers, mit dem er verbunden ist, angeordnet ist.

7.  Vorrichtung nach einem der Ansprüche 5 oder 6, **dadurch gekennzeichnet, dass** ein Port (311) des Analysators (31) mindestens ein Sendemodul zum Erzeugen des Sendesignals, welches dazu bestimmt ist, an die Kanäle (33) gesendet zu werden, beinhaltet.

8.  Vorrichtung nach Anspruch 7, **dadurch gekennzeichnet, dass** es einen Koppler (37) am Ausgang des Sendemoduls beinhaltet, wobei der Port (311) mindestens einen Empfänger beinhaltet, um ein Referenzsignal, welches von dem Sendesignal über den Koppler (37) stammt, zu empfangen.

9.  Vorrichtung nach einem der Ansprüche 7 oder 8, **dadurch gekennzeichnet, dass** der Port (311) einen zweiten Empfänger beinhaltet, welcher ein Signal empfängt, welches aus einem Netzwerk (38) stammt, welches aus einigen Strahlelementen der Antenne gebildet wird.

**Claims**

1. Method for calibrating an electronic scanning antenna composed of radiating elements which each form an active channel in which the signals originating from the channels are grouped together, on the one hand, in order to form deviation measurement signals, each deviation measurement signal forming a deviation measurement channel, and are grouped together, on the other hand, in accordance with sectors ($S_1$, $S_2$, .... $S_M$) in order to form one signal per sector forming a sector channel, one beam per calculation being formed from the signals originating from each of the sectors, **characterised in that** it comprises at least the following steps:

   - measuring (21) the response to a calibration signal of each active channel both on the sum deviation measurement channel and on the sector channel to which it belongs, the responses on the sum channel enabling the calibration of the sum channel to be obtained;
   - calculating, for each active channel, the deviation between the mean of the responses measured on the sum channel and the mean of the responses measured on the sector to which it belongs;
   - in the operational phase, forming the beam by calculation from the measurements of the signals originating from the sector channels calibrated with the calibration obtained for the sum channel, and correcting (23) the calculation of the group in accordance with the deviation.

2. Method according to claim 1, **characterised in that** the measurement of the response to a calibration signal of each active channel both on the sum deviation measurement channel and on the sector channel to which it belongs is carried out in the same instantaneous measurement sequence.

3. Method according to either of the preceding claims, **characterised in that** the measurements of the signals originating from the sector channels are carried out in the same instantaneous measurement sequence.

4. Method according to any one of the preceding claims, **characterised in that** the signal received by the beam formed by the calculation, referred to as the *Signal_FFC,* is obtained in accordance with the following relationship:

$$Signal\_FFC = \sum_{i=1}^{M} B_i \, e^{j\psi_i}.Voie\_secteur(i).Cor\_secteur(i)$$

where:

   - M is the number of sectors;
   - *Voie_secteur(i)* is the measurement of the signal originating from the channel of the $i^{th}$ sector calibrated with the calibration obtained for the sum channel, i varying from 1 to M;
   - $B_i e^{j\psi_i}$ is a complex weight assigned to the $i^{th}$ sector;
   - *Cor_secteur(i)* represents the deviation between the mean of the responses measured on the sum channel and the mean of the responses measured on the $i^{th}$ sector.

5. Measuring device for implementing the method according to any one of the preceding claims, **characterised in that** it comprises at least:

   - a multiport network analyser (31) which comprises a total number P of receivers, the analyser being capable of measuring the signals originating from the active channels in response to the calibration signal;
   - a set (32) of K commutators (11, 12, 13, 14, 15, 16) which each have Q input channels and an output channel at which one of the input channels is branched, the commutators being controlled by the analyser, the input channels being capable of each receiving a signal from an active channel of the antenna in response to the calibration signal, the output channels each being connected to one of the P receivers;

   the analyser (31) launching successively Q measurements in accordance with the following sequence:

   - on receiving a measurement instruction signal, the analyser (31) controlling the commutators so that they each commute the first input channel thereof on their output channel, then launching the measurement on the P receivers thereof of the signals originating from P first active channels;
- then the analyser (31) controlling the commutators so that they each select their second input channel on the output channel thereof, then launching the measurement on the P receivers thereof of the signals originating from P following active channels;

and so forth until the analyser (31) controlling the commutators causes them to each branch their Qth input channel at their output channel.

6. Device according to claim 5, **characterised in that** an amplifier (34) is arranged between each commutator output and the input of the receiver to which it is connected.

7. Device according to either claim 5 or 6, **characterised in that** a port (311) of the analyser (31) comprises at least one transmission module in order to generate the transmission signal which is intended to be transmitted to the channels (33).

8. Device according to claim 7, **characterised in that** it comprises a coupler (37) at the outlet of the transmission module, the port (311) comprising at least one receiver in order to receive a reference signal originating from the transmission signal via the coupler (37).

9. Device according to either claim 7 or 8, **characterised in that** the port (311) comprises a second receiver which receives a signal from a network (38) formed by a number of radiation elements of the antenna.

Formateur de
voie classique

2

Vers N éléments
rayonnants
munis de
modules actifs

Partie du
formateur de
voie gérant les
secteurs

3

$\Sigma$

$\Delta G$

$\Delta S$

$S_1$

$S_2$

$S_M$

Formateur de voie sectorisé

1

FIG.1

EFFECTUER SIMULTANEMENT LES MESURES
DE CALIBRATION SUR LA VOIE $\Sigma$
ET LES VOIES SECTEURS

21

STOCQUER LA CALIBRATION $\Sigma$ ET L'APPLIQUER
EN FONCTIONNEMENT OPERATIONNEL

22

CORRECTION DES SIGNAUX FFC

23

FIG.2

FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0904045
- FR 1103143
- FR 1302928

**Littérature non-brevet citée dans la description**

- **C. RENARD.** Calibration et mesure faible coût d'une antenne à balayage électronique active. *Workshop CNES,* Décembre 1998
- **E.GRORUD et al.** Design and Measurement of an active array antenna for an airborne X-band SAR/MTI Radar. *EUCAP Nice,* 2006
- **C. RENARD.** Etalonnage des antennes aéroportées. *CCT CNES,* Janvier 2009